# FASCICULE DE BREVET EUROPEEN

(11) **EP 3 559 994 B1**
(45) Date de publication et mention de la délivrance du brevet: **04.11.2020**
(21) Numéro de dépôt: 17821580.2
(22) Date de dépôt: 18.12.2017
(51) Int. Cl.: H01L 27/146, H01L 27/144, H01L 31/101

(54) **CAPTEUR MULTI -SPECTRAL À PHOTODÉTECTEURS EMPILÉS**
MULTISPEKTRALER SENSOR MIT GESTAPELTEN PHOTODETEKTOREN
MULTI-SPECTRAL SENSOR WITH STACKED PHOTODETECTORS

(30) Priorité: 20.12.2016 FR 1662932
(43) Date de publication de la demande: 30.10.2019
(73) Titulaire: SORBONNE UNIVERSITE, 75006 Paris (FR)
(72) Inventeur: BEN CHOUIKHA, Mohamed, 93300 Aubervilliers (FR); DUBOIS, Gérard, 77380 Combs La Ville (FR)
(74) Mandataire: Gevers & Orès
(86) Numéro de dépôt international: PCT/EP2017/083392
(87) Numéro de publication internationale: WO 2018/114854

(56) Documents cités:
- WO-A1-2005/119790
- US-A1- 2014 374 866
- TOPIC M ET AL: "STACKED A-SI:H-BASED THREE-COLOUR DETECTORS", JOURNAL OF NON-CRYSTALLINE SOLIDS, NORTH-HOLLAND PHYSICS PUBLISHING. AMSTERDAM, NL, vol. 227/230, 2 mai 1998 (1998-05-02), pages 1326-1329, XP000668508, ISSN: 0022-3093, DOI: 10.1016/S0022-3093(98)00211-7

## Description

L'invention concerne un capteur multi-spectral.

Les capteurs couleur et/ou multi-spectraux classiques, par exemple de type CCD ou CMOS, nécessitent un jeu de filtres optiques ou un système optique de dispersion pour mesurer la couleur ou/et la composition spectrale d'un rayonnement incident. La qualité de l'image ainsi obtenue par la décomposition spectrale est alors dégradée par le tramage effectué par les filtres optiques. Ce tramage est par exemple responsable du phénomène de moiré apparaissant dans les images couleurs présentant de hautes fréquences spatiales.

Par ailleurs, avec ces capteurs multi-spectraux classiques, la résolution obtenue est également limitée du fait que plusieurs photodétecteurs du capteur multi-spectral sont employés pour détecter une couleur.

On a donc cherché à résoudre ces problèmes.

Une solution à ces problèmes est par exemple proposée dans le document US 5 883 421 (D1).

Dans le document D1, le capteur multi-spectral proposé est basé sur une technique toute autre, dite à jonctions enterrées. Topic et al. ("STACKED A-SI:H-BASED THREE-COLOUR DETECTORS",JOURNAL OF NON-CRYSTALLINE SOLIDS, NORTH-HOLLAND PHYSICS PUBLISHING. AMSTERDAM, NL, vol. 227/230, 2 mai 1998 (1998-05-02), pages 1326-1329) décrit un capteur multi-spectral.

Toutefois, cette technique présente certaines limites.

En particulier, la différence de dopage entre deux régions successives de semiconducteur de type différent (n et p) doit être de l'ordre de deux décades pour obtenir des profondeurs de jonctions définies et reproductibles ainsi qu'une ZCE (Zone de Charge d'Espace) significative.

Par ailleurs, la formation des régions de types différents successives (n et p) est effectuée en introduisant pour chaque région une concentration d'impuretés supplémentaire afin de réaliser le dopage souhaité. La concentration d'impuretés introduites ne cesse d'augmenter et peut rapidement atteindre la limite d'impureté pouvant être introduite dans le semi-conducteur.

En pratique, ceci limite la fabrication à quelques jonctions enterrées, à savoir pas plus de cinq. En conséquence, le nombre de longueurs d'ondes d'intérêt pouvant être analysées est limité.

Par ailleurs, les paires électrons-trous générées dans les régions neutres d'une jonction enterrée ne participent que partiellement à la génération de photo-courants. En conséquence, le rendement quantique d'un tel capteur multi-spectral est limité.

De plus, la réponse temporelle d'un tel capteur multi-spectral est limitée par les courants de diffusion, qui sont en général plus importants que les courants de transit, et par les valeurs non négligeables des capacités de jonctions.

Enfin, il convient de noter que, que ce soit pour une technique classique de type CCD ou CMOS ou une technique plus avancée dite à jonction enterrée, il n'est pas possible de prendre une image mufti-spectrale en une seule prise.

Un objectif de l'invention est de résoudre l'un au moins des inconvénients précités.

A cet effet, l'invention propose un capteur multi-spectral comprenant :
- une pluralité de N photodétecteurs avec N un nombre entier tel que N ≥2, chaque photodétecteur comportant une anode et une cathode séparées l'une de l'autre par une région d'intérêt, l'anode, la cathode et la région d'intérêt étant toutes réalisées en un matériau semi-conducteur ;
   lesdits photodétecteurs étant empilés les uns sur les autres de sorte que les anodes d'une part, les cathodes d'autre part et les régions d'intérêt enfin de deux photodétecteurs consécutifs dans l'empilement soient agencées face à face, cet empilement permettant de définir une face dite face active du capteur multi-spectral, commune à l'ensemble des photodétecteurs de l'empilement, définie par la face de la première région d'intérêt du premier photodétecteur de l'empilement par laquelle des photons sont destinés à entrer dans l'empilement ; et
- soit, dans un premier cas, un contact électrique associé à chacune des N cathodes et au moins un contact électrique pour les N anodes, les cathodes consécutives dans l'empilement, agencées face à face, étant alors séparées par une couche d'isolation ;
- soit, dans un deuxième cas, un contact électrique associé à chacune des N anodes et au moins un contact électrique pour les N cathodes, les anodes consécutives dans l'empilement, agencées face à face, étant alors séparées par une couche d'isolation.

Ce capteur multi-spectral pourra comprendre l'une au moins des caractéristiques suivantes :
- Il comprend, entre deux photodétecteurs consécutifs dans l'empilement, une couche d'isolation séparant les régions d'intérêt agencées face à face ;
- chaque photodétecteur comporte, au sein de la région d'intérêt associée, une languette qui est dans le premier cas, au moins en contact avec la cathode concernée et réalisée avec un dopage du même type que cette cathode, ladite languette s'étendant, au sein de la région d'intérêt, en direction de l'anode ; dans le deuxième cas, au moins en contact avec l'anode concernée et réalisée avec un dopage du même type que cette anode, ladite languette s'étendant, au sein de la région d'intérêt, en direction de la cathode ;
- la ou chaque languette présente une épaisseur comprise entre 10nm et 50nm ;
- il comprend un gradient de concentration du dopage du matériau semi-conducteur de la région d'intérêt du premier photodétecteur de l'empilement, situé au niveau de ladite face active ;
- il comprend, en outre, une couche de passivation sur ladite face active ;
- la couche de passivation est réalisée avec un oxyde ou du verre comportant du phosphore ;
- il est prévu une couche isolante, par exemple réalisée avec un oxyde, dans le premier cas, entre chaque contact électrique de la cathode et la cathode associée afin de former un condensateur entre le contact électrique de la cathode et la cathode associée ; dans le deuxième cas, entre chaque contact électrique de l'anode et l'anode associée afin de former un condensateur entre le contact électrique de l'anode et l'anode associée ;
- pour chaque photodétecteur, la région d'intérêt est réalisée en un matériau semi-conducteur intrinsèquement dopé ;
- pour chaque photodétecteur, l'anode est réalisée en un matériau semi-conducteur dopé P+ et la cathode est réalisée en un matériau semi-conducteur dopé N+.

D'autres caractéristiques, buts et avantages de l'invention ressortiront à la lecture de la description faite en référence aux dessins annexés donnés à titre d'exemple, pour lesquels :
- la figure 1 représente un premier mode de réalisation d'un capteur multi-spectral conforme à l'invention ;
- la figure 2 représente un deuxième mode de réalisation d'un capteur multi-spectral conforme à l'invention ;
- la figure 3 représente un troisième mode de réalisation d'un capteur multi-spectral conforme à l'invention ;
- la figure 4 représente un quatrième mode de réalisation d'un capteur multi-spectral conforme à l'invention ;
- la figure 5 représente une variante de réalisation, en l'occurrence représentée par rapport au premier mode de réalisation, mais applicable à l'ensemble des quatre modes de réalisation des figures 1 à 4 ;
- la figure 6 représente une autre variante de réalisation, en l'occurrence représentée par rapport au premier mode de réalisation, mais applicable à l'ensemble des quatre modes de réalisation des figures 1 à 4 et à la variante de réalisation de la figure 5 ;
- la figure 7 représente un capteur mufti-spectral conforme à l'invention qui a fait l'objet de simulations numériques pour en tester son efficacité ;
- la figure 8 représente la réponse spectrale du capteur multi-spectral de la figure 7 ;
- la figure 9 représente la réponse spectrale du capteur multi-spectral de la figure 3 ;
- la figure 10 représente un autre mode de réalisation, à comparer à celui de la figure 1 ;
- la figure 11 représente encore un autre mode de réalisation, à comparer à celui de la figure 3.

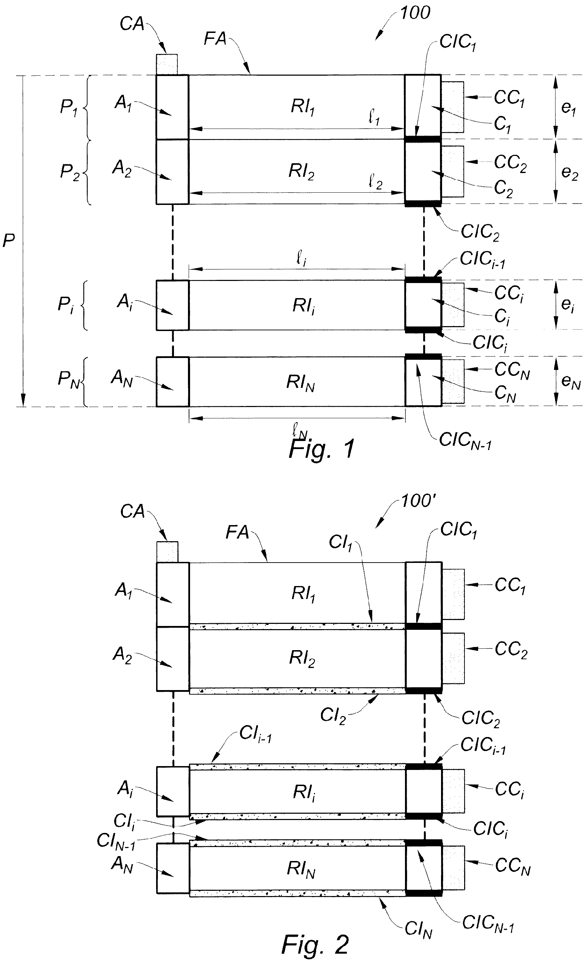

Un premier mode de réalisation d'un capteur multi-spectral conforme à l'invention est représenté sur la figure 1.

Le capteur 100 multi-spectral comprend une pluralité de N photodétecteurs P₁,..., P_{N} avec N un nombre entier tel que N ≥ 2. Chaque photodétecteur comporte une anode A₁, ..., A_{N} et une cathode C₁, ..., C_{N} séparées l'une de l'autre par une région d'intérêt R_{I1}, ..., R_{IN}. Par ailleurs, pour chaque photodétecteur P₁,..., P_{N}, l'anode, la cathode et la région d'intérêt sont réalisées en un matériau semi-conducteur.

Le photodétecteur 100 multi-spectral comprend également au moins un contact électrique CA pour l'ensemble des N anodes A₁, ..., A_{N} ainsi qu'un contact électrique CC₁, ..., CC_{N} associé à chacune des N cathodes.

Dans le cas d'espèce et comme représenté sur la figure 1, un contact électrique CA commun est prévu pour l'ensemble des anodes A₁, ..., A_{N}. En pratique, chaque contact électrique CA, CC₁, ..., CC_{N} peut être réalisé en un matériau choisi parmi un métal, un alliage métallique ou à base d'un poly-cristal dopé dégénéré tel que le silicium poly-cristallin. Les photo-courants (ou les chargés photo-générées) dans chaque photodétecteur P₁,..., P_{N} sont collectés à travers le contact électrique CC₁, ..., CC_{N} correspondant. Les photo-courants sont ainsi collectés séparément sans qu'il y ait redistribution de charges entre les cathodes.

Chaque photodétecteur présente une structure de type PIN.

Dans le cadre de l'invention, les photodétecteurs P₁,..., P_{N} sont par ailleurs empilés les uns sur les autres de sorte que les anodes A₁, ..., A_{N} d'une part, les cathodes C₁, ..., C_{N} d'autre part et les régions d'intérêt R_{I1}, ..., R_{IN} enfin de deux photodétecteurs consécutifs dans l'empilement soient agencées face à face. En d'autres termes, si l'on considère deux photodétecteurs Pᵢ, Pᵢ₊₁ avec 1≤ i ≤ N-1 de cet empilement, les anodes Aᵢ, Aᵢ₊₁ se font face, les cathodes Cᵢ, Cᵢ₊₁ se font face et les régions d'intérêt RIᵢ, RIᵢ₊₁ se font également face.

Afin d'isoler entre elles les cathodes qui se font face, on prévoit une couche d'isolation CIC₁, CIC₂, ..., CICᵢ₋₁, CICᵢ, ..., CIC_{N-1}, entre deux cathodes qui se font face. Ceci permet d'éviter que des photo-courants générés dans un photodétecteur Pᵢ donné soient collectés par une cathode associée à un autre photodétecteur. Chacune de ces couches d'isolation peut être réalisée avec une implantation ionique, par exemple avec un dopage de type P+, sur la cathode correspondante.

Du fait de cet empilement, on note qu'il existe une face dite face active FA du capteur 100 multi-spectral, commune à l'ensemble des photodétecteurs de l'empilement, et définie par la face de la première région d'intérêt RI₁ du premier photodétecteur P₁ de l'empilement par laquelle des photons sont destinés à entrer dans l'empilement.

Avec cet empilement, on peut représenter certains paramètres géométriques du capteur 100 multi-spectral.

Ainsi, on peut définir, pour le i^{ème} photodétecteur de l'empilement une distance dᵢ avec 1≤ i ≤ N prise entre la face active FA et le i^{ème} photodétecteur P₁,..., P_{N} de l'empilement (on notera le cas particulier d₁ = 0). Cette distance dᵢ définit la profondeur à laquelle se situe le i^{ème} photodétecteur de l'empilement, au sein du capteur 100 multi-spectral.

On peut également définir l'épaisseur eᵢ d'un photodétecteur Pᵢ, cette épaisseur étant notamment celle d'une région d'intérêt de ce photodétecteur Pᵢ. Cette épaisseur s'exprime eᵢ = dᵢ₊₁ - dᵢ, avec 1 ≤ i ≤ N et est en conséquence, prise selon la profondeur du photodétecteur 100 multi-spectral (on notera que la distance d_{N+1} correspond à la distance séparant la face active FA du photodétecteur 100 multi-spectral de sa face de fond FF). Typiquement, cette épaisseur eᵢ d'une région d'intérêt RI₁, ..., RI_{N} pourra être comprise entre quelques dizaines de nm à plusieurs micromètres, par exemple entre 20nm et 5 microns.

En pratique, chaque région d'intérêt de l'empilement absorbe des longueurs d'onde selon une courbe en « cloche » centrée sur la longueur d'onde d'intérêt (longueur d'onde du pic de la cloche).

Une fois la nature du matériau semi-conducteur choisi, la profondeur dᵢ à laquelle un photodétecteur Pᵢ avec 1≤ i ≤ N est situé au sein de l'empilement et l'épaisseur eᵢ de ce photodétecteur Pᵢ, et plus précisément d'une région d'intérêt RIᵢ avec 1≤ i ≤ N, permettent de définir la longueur d'onde d'intérêt et la largeur à mi-hauteur (autour du pic) de la courbe en « cloche », cette largeur à mi-hauteur définissant la sélectivité en longueur d'onde du photodétecteur considéré.

On comprend que chaque photodétecteur P₁,..., P_{N} de l'empilement est dédié à la détection d'une plage de longueurs d'onde d'intérêt donnée et que le caractère multi-spectral du capteur multi-spectral provient de la présence d'une pluralité de photodétecteurs empilés comme proposé dans le cadre de l'invention. On comprend également que la présence d'un contact électrique CCᵢ pour chaque photodétecteur Pᵢ est importante pour appliquer la polarisation inverse nécessaire et pour pouvoir mesurer le signal électrique photo-généré dans chaque photodétecteur.

On notera que l'agencement du capteur 100 multi-spectral permettra de détecter les longueurs d'ondes les plus courtes près de la face active FA et des longueurs d'onde de plus en plus grandes au fur et à mesure que la distance dᵢ du photodétecteur est profonde dans l'empilement.

Le matériau semi-conducteur formant chaque photodétecteur P₁,..., P_{N} sera choisi en fonction de la gamme de longueur d'onde que l'on souhaite analyser.

Ainsi, on peut envisager du silicium (Si) pour une gamme de longueur d'onde comprise entre 0,2µm et 1,1µm, du germanium (Ge) pour longueur d'onde comprise entre 0,2µm et 1,7µm.

On peut envisager de l'Arséniure de Gallium (GaAs) pour une gamme de longueur d'onde comprise entre 0,2µm et 0,9µm.

D'autres matériaux semi-conducteurs sont envisageables, tels que l'Arséniure de Gallium-Indium (InGaAs) pour la gamme de longueur d'onde allant de 1µm à 1,7µm, l'Arséniure d'Indium (Asln) pour la gamme de longueur d'onde allant de 1µm à 3,5µm, l'Antimoniure d'Indium (InSb) pour la gamme de longueur d'onde allant de 1µm à 6µm, ou encore le Tellurure de Mercure-Cadnium (HgCdTe) pour la gamme de longueur d'onde allant de 4µm à 13µm.

Une fois le matériau semi-conducteur choisi, le nombre N de photodétecteurs P₁,..., P_{N} sera déterminé en fonction de la gamme de longueurs d'ondes que l'on souhaite analyser avec le capteur 100 multi-spectral et de la sélectivité de la décomposition souhaitée.

Il est donc possible, contrairement à la technique proposée dans le document D1, d'augmenter à souhait le nombre N de photodétecteurs de l'empilement en fonction de la décomposition spectrale requise par l'application.

Dans le cadre de l'invention, le nombre N de photodétecteurs de l'empilement n'est limité que par la profondeur ou épaisseur totale de l'empilement qui ne doit pas dépasser une valeur correspondant à une absorption totale des photons incidents. En effet, à partir d'une certaine profondeur ou épaisseur totale, les photons sont totalement absorbés et ne pénètrent plus dans le matériau. Dans ce cas, un empilement plus épais ne présente aucun intérêt.

En pratique, et dans le cadre de l'invention, on peut toutefois aller bien au-delà de N > 10.

On peut enfin définir la largeur Iᵢ avec 1≤ i ≤ N d'une région d'intérêt R_{I1}, ..., R_{IN} de chaque photodétecteur P₁,..., P_{N} de l'empilement. Cette largeur Iᵢ est prise perpendiculairement à la profondeur de l'empilement.

Le choix de la largeur Iᵢ d'un photodétecteur Pᵢ dépend de l'application envisagée. Certaines applications nécessitent des photodétecteurs (encore appelés pixels) de petite taille, c'est-à-dire présentant une surface de 1 µm² à 6µm²) afin d'augmenter la résolution spatiale et la définition de l'image capturée. D'autres applications nécessitent des capteurs de grande taille, afin par exemple d'augmenter la sensibilité dans des conditions de faible éclairage (capteurs d'image à grande surface pour les télescopes par exemple). Ainsi, pour un capteur d'image, cette largeur Iᵢ d'une région d'intérêt RI₁, ..., RI_{N} pourra être comprise entre quelques centaines de nanomètres et quelques microns voire des dizaines de microns, par exemple entre 200nm et 50 microns. Elle peut être de l'ordre de quelques centaines de microns pour des capteurs spécifiques, à savoir entre 200 microns à 800microns. Elle peut être de quelques millimètres à quelques dizaines de millimètres, par exemple entre 2mm et 50mm, pour un détecteur multi-spectral monocanal.

L'application envisagée va donc définir la surface du photodétecteur et par conséquence la valeur de la longueur Iᵢ d'une région d'intérêt.

Toutefois, quelle que soit l'application envisagée, la structure proposée dans le cadre de l'invention permet d'obtenir une efficacité quantique excellente (proche de la valeur unité), donc meilleure que celle du capteur multi-spectral proposé dans le document D1.

En effet, dans le cadre de l'invention, la structure de chaque photodétecteur (PIN, choix des dopages pour former ce PIN) et, en utilisation, la valeur de polarisation inverse appliquée au photodétecteur permettent d'ajuster la ZCE de façon à ce qu'elle s'étende sur toute la longueur lᵢ. Ainsi, tous les porteurs créés dans un photodétecteur sont séparés par le champ électrique qui règne dans la ZCE et forment le photo-courant qui traverse la PIN. La composante du photo-courant est essentiellement une composante de transit et la composante de diffusion est négligeable.

La capacité du photodétecteur de type PIN dépend de la ZCE et sa valeur est plus précisément proportionnelle au rapport eᵢ/lᵢ, du fait qu'en pratique, la ZCE peut être réglée pour s'étendre sur toute la longueur lᵢ. Par rapport à un détecteur classique de même surface active, la capacité est réduite dans le rapport eᵢ/lᵢ.

Par ailleurs, et de manière générale, le temps de réponse d'un photodétecteur est défini par sa capacité (capacité de la structure PIN, diode) et ses résistances parasites, par le temps de transit des charges dans la ZCE, et par le temps de diffusion (avant d'arriver à la ZCE).

Généralement, pour les photodétecteurs de l'art antérieur, le temps de réponse est limité par le temps de diffusion, qui est alors typiquement compris entre 10⁻⁸ et 10⁻⁹ s.

Toutefois, dans le cadre de l'invention, le temps de diffusion est négligeable devant le temps de transit dans la ZCE.

Toujours dans le cadre de l'invention, le temps de transit d'un photodétecteur Pᵢ est de l'ordre de 10⁻¹¹s et le temps de réponse dû à la capacité du photodétecteur et à ses résistances parasites est estimé à 10⁻¹⁶ s pour une résistance série estimée variant de 10 Ω à 100 Ω et une capacité de 10 nF/cm².

En conséquence, dans le cadre de l'invention, le temps de réponse du photodétecteur est finalement déterminé par le seul temps de transit dans la ZCE du photodétecteur Pᵢ.

On peut donc améliorer le temps de réponse d'un photodétecteur Pᵢ, par rapport à ce qui est proposé dans l'art antérieur et en particulier dans le document D1, sans modifier pour autant la sélectivité de ce photodétecteur Pᵢ. Pour rappel, cette sélectivité est déterminée par l'épaisseur eᵢ, mais aussi par la profondeur dᵢ. Quant au temps de réponse du capteur multi-spectral 100 dans son ensemble, il correspondra au plus long temps de réponse d'un photodétecteur de l'empilement.

Typiquement, le rapport eᵢ/lᵢ peut être de l'ordre de 10 pour un photodétecteur Pᵢ en profondeur destiné à capter les grandes longueur d'onde et ayant une face active FA dont la surface est faible (par exemple, une épaisseur eᵢ = 5µm et une largeur lᵢ = 0,5 µm). Ce rapport peut être de l'ordre 10⁻³ pour un photodétecteur Pᵢ en surface (profondeur faible ou nulle) destiné à capter les faibles longueur d'onde et ayant une face active dont la surface est élevée (par exemple, une épaisseur eᵢ = 50 nm et une largeur lᵢ = 50 µm).

Enfin, on comprend que contrairement aux techniques de l'art antérieur, on peut faire l'analyse multi-spectrale en une seule prise. En effet, l'empilement considéré dans le cadre de l'invention et le fait qu'un contact électrique soit associé à chaque cathode le permet.

Quel que soit le matériau semi-conducteur choisi, la fabrication du photodétecteur 100 multi-spectral pourra commencer par une épitaxie du photodétecteur P_{N} (le plus profond une fois l'empilement réalisé), en partant d'un matériau semi-conducteur intrinsèquement dopé, par exemple du silicium. Les conditions de l'épitaxie vont permettre de déterminer l'épaisseur e_{N} du photodétecteur P_{N}. L'anode A_{N} est alors avantageusement réalisée par une implantation ionique permettant de réaliser un dopage P. La cathode C_{N} est alors avantageusement réalisée par une implantation ionique permettant de réaliser un dopage N.

Puis, un dopage P+ d'isolation (cela correspond à la couche CIC_{N-1}) est réalisé par une implantation ionique au dessus de la cathode C_{N} pour l'isoler la cathode C_{N-1}, cette dernière étant destinée à être réalisée ultérieurement.

On répète ensuite ces étapes pour réaliser les autres photodétecteurs P_{N-1} à P₁ de l'empilement.

Ensuite, les contacts électriques sont réalisés par un procédé classique de contact et métallisation.

Le procédé de fabrication du capteur 100 multi-spectral sera détaillé par la suite dans le cadre d'un exemple concret, notamment sur la façon dont les contacts électriques des différentes cathodes sont agencées afin d'être compatibles avec les technologies « planar » de fabrication de CI, CMOS ou BiCMOS.

Un deuxième mode de réalisation de l'invention est représenté sur la figure 2.

Il se distingue du premier mode de réalisation par la présence, au sein du photodétecteur 100' multi-spectral, entre deux photodétecteurs consécutifs Pᵢ, Pᵢ₊₁ avec 1 ≤ i ≤ N-1 dans l'empilement, d'une couche d'isolation additionnelle CI₁, CI₂, ... CIᵢ₋₁, CIᵢ, ..., CI_{N-1} séparant les régions d'intérêt RIᵢ qui se font face.

Une telle couche d'isolation a pour intérêt de limiter le passage de porteurs de charges d'un photodétecteur à l'autre au sein de l'empilement. Elle a pour effet de confiner les porteurs dans le photo-détecteur Pᵢ dans lequel ils ont été photo-générés. Par conséquent, elle permet de limiter la fuite des porteurs (plus connu sous le nom de « crosstalk » selon la terminologie anglo-saxonne) entre les différents photodétecteurs P₁, ..., P_{N}.

Une telle couche CI_{N} peut aussi être prévue au fond de l'empilement.

En effet, les photo-porteurs générés par l'interaction entre le rayonnement incident et une région d'intérêt RIᵢ d'un photodétecteur Pᵢ sont accélérés par le champ électrique (horizontal, orienté selon la direction perpendiculaire à celle définie pour la profondeur P d'un photodétecteur) imposé entre l'anode Aᵢ et la cathode Cᵢ du photodétecteur considéré pour contribuer au signal électrique circulant dans ce photodétecteur.

Cependant, les chocs subis par les photo-porteurs durant leur traversée de la ZCE (entre l'anode et la cathode associé au photodétecteur Pᵢ) peuvent donner lieu à un phénomène de diffusion, dans le cas particulier où le gradient horizontal du potentiel est faible. Cette diffusion peut impliquer que certains photo-porteurs générés dans le photodétecteur Pᵢ se retrouvent dans un autre photodétecteur de l'empilement.

Par ailleurs, si la structure du capteur 100 multi-spectral fait qu'il se crée un gradient de potentiel vertical, les porteurs photo-générés dans les différents photodétecteurs P₁, ..., P_{N} peuvent être déviés de leur trajectoire horizontale et peuvent se mélanger.

Ceci peut dégrader la sélectivité de la réponse spectrale de chaque photodétecteur de l'empilement (pouvoir de séparation entre différentes longueurs d'onde).

Pour réaliser une telle couche, le plus simple est une fois qu'un photodétecteur P_{N} a été réalisé (cf. précédemment), de réaliser une implantation ionique permettant d'avoir sur une épaisseur donnée, un dopage, par exemple de type P, au niveau de la région d'intérêt RI_{N}.

Ceci est ensuite répété pour chaque photodétecteur P_{N-1} à P₁.

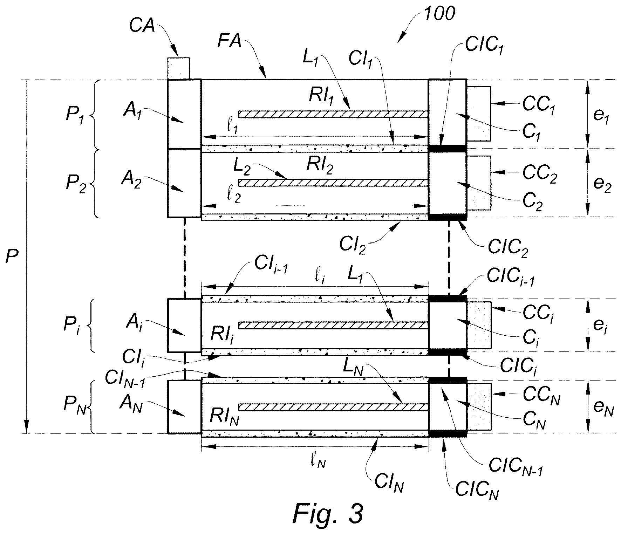

Un troisième mode de réalisation est représenté sur la figure 3.

Le troisième mode de réalisation se différencie du deuxième mode de réalisation par la présence, dans au moins une région d'intérêt RIᵢ avec i choisi entre 1 et N, mais avantageusement et comme représenté sur la figure 3, dans chacune de ces régions d'intérêt Rᵢ, d'une languette, L₁, L₂, ..., Lᵢ,...L_{N}. Cette ou chaque languette est en contact avec la cathode Cᵢ correspondante et s'étend en direction de l'anode Aᵢ correspondante. On peut envisager que cette languette vienne au contact de l'anode correspondante, même si cela n'est pas obligatoire, comme cela est représenté sur la figure 3, sur laquelle la languette Lᵢ n'est pas en contact avec l'anode Ai. Cette ou chaque languette est réalisée avec le même type de dopage que la cathode correspondante, mais avec un dopage plus faible.

L'intérêt d'une telle languette L réside dans le fait qu'elle permet de mieux confiner les porteurs photo-générés dans le ou chaque photodétecteur Pᵢ concerné. En conséquence, cela permet, en utilisation, d'avoir une ZCE la plus étendue possible sur la longueur Iᵢ en diminuant la polarisation inverse appliquée entre l'anode et la cathode. La consommation d'énergie est donc diminuée.

A cette fin, une languette Lᵢ présentera avantageusement une épaisseur (définie selon la profondeur P du capteur multi-spectral) comprise entre 10nm et 50nm.

Bien entendu, on pourrait prévoir une variante de réalisation incluant de telles languettes, en ajoutant ces languettes à partir du premier mode de réalisation. Dans ce cas, on se retrouverait avec le schéma de la figure 3, mais sans les couches d'isolation CI₁, CI₂, ..., CIᵢ₋₁, Cᵢ, ..., CI_{N-1} entre les régions d'intérêt RI₁, RI₂, ..., RIᵢ₋₁, RIᵢ, ..., RI_{N-}1 qui se succèdent dans l'empilement, voire même sans la couche CI_{N}.

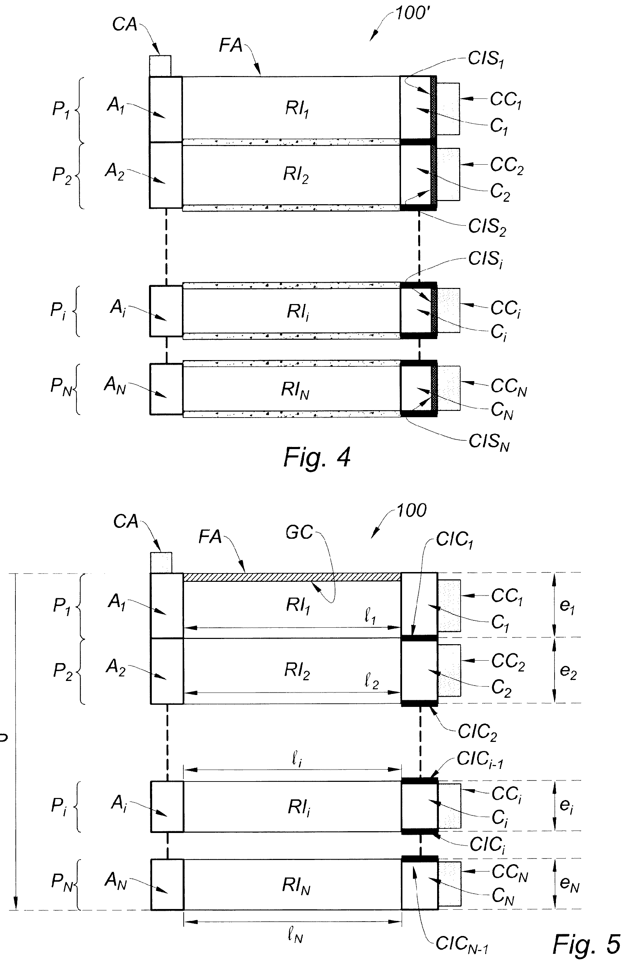

Un quatrième mode de réalisation est représenté sur la figure 4.

Ce quatrième mode de réalisation se distingue du premier mode de réalisation par la présence d'une couche d'isolant électrique CIS₁, ..., CIS_{N} entre chaque contact électrique CC₁, ..., CC_{N} et la cathode C₁, ..., C_{N} associée.

Ceci permet de former un condensateur entre le contact électrique et la cathode associée. Avantageusement, cette couche d'isolant électrique CIS₁, ..., CIS_{N} est réalisée avec un oxyde. En particulier, si le contact électrique est à base métallique ou en un poly-cristal dopé dégénéré (poly-Si par exemple), on forme ainsi un condensateur MOS (Métal - Oxyde - Semiconducteur).

Dans ce mode de réalisation, la cathode C₁, ..., C_{N} de chaque photodétecteur P₁, ..., P_{N} forme un puits de potentiel dans lequel les charges générées pendant le temps d'insolation du photodétecteur 100" multi-spectral sont accumulées. Ces charges accumulées peuvent ensuite être transférées, lorsque cela est souhaité, vers un dispositif de lecture (non représenté) en appliquant une tension appropriée sur le condensateur MOS.

La valeur de la capacité du condensateur MOS dépend de l'épaisseur de la couche d'isolation électrique et de sa surface. Sa surface sera liée à l'épaisseur eᵢ d'un photodétecteur P₁, ..., P_{N} de l'empilement. Par ailleurs, et typiquement, la couche d'isolant électrique CIS₁, ..., CIS_{N} présentera une épaisseur comprise entre 2 nm et 50 nm.

On comprend qu'avec ce quatrième mode de réalisation, chaque photo-détecteur P₁, ..., P_{N} de l'empilement constitue un photodétecteur CCD (acronyme signifiant « Charge Coupled Device » selon la terminologie anglo-saxonne).

Avec la conception proposée dans ce quatrième mode de réalisation, on définit donc un photodétecteur 100" multi-spectral pouvant être classé dans les techniques CCD, mais avec tous les avantages procurés par la conception proposée dans le cadre de l'invention.

En pratique, on réalise tout d'abord l'épitaxie du capteur multispectral P₁, P₂, ...,Pᵢ, ..., P_{N}. On réalise ensuite une tranchée sur l'épaisseur épitaxiée, à l'endroit souhaité, à travers un masque. On oxyde ensuite le flanc de la tranchée réalisée, avantageusement par une oxydation thermique, et on dépose une grille métallique pour chaque photodétecteur Pᵢ. Cette grille est avantageusement en poly-cristal dopé dégénéré tel que le polysilicium dopé.

Avantageusement, une seule couche de polysilicium sert de grille pour l'ensemble des photo-détecteurs Pᵢ.

En variante, les grilles des photodétecteurs Pᵢ sont séparées entre elles par des couches d'isolant. Dans ce cas, la grille du photodétecteur P_{N} est tout d'abord déposée suivie du dépôt d'une couche d'isolant. Ces étapes sont ensuite répétées pour chacun des photo-détecteurs P_{N-1} à P₁.

Ceci s'effectue avantageusement après le dopage visant à former l'anode et la cathode.

En pratique, on peut envisager les diélectriques suivants dans le cas du silicium pour réaliser la couche isolante électriquement : l'oxyde du silicium (SiO₂) ou le nitrure de silicium (Si₃N₄).

Ce quatrième mode de réalisation peut bien entendu intégrer les couches CI₁, .., CI_{N} du mode de réalisation de la figure 2 et c'est d'ailleurs ce qui est représenté sur la figure 4 En variante, il peut aussi intégrer les languettes décrites à l'appui de la figure 3.

Toutefois, dans le cadre de l'invention, il n'est pas obligatoire de prévoir les couches CI₁, .., CI_{N} (cas non représenté).

La figure 5 représente une variante applicable aux quatre modes de réalisation décrits précédemment.

Elle est toutefois fournie en référence au premier mode de réalisation.

Dans cette variante, on prévoit un gradient de concentration GC du dopage du matériau semi-conducteur de la région d'intérêt RI₁ du premier photodétecteur P₁ de l'empilement, au niveau de la face active FA.

Ceci peut être réalisé soit par implantation d'impuretés en surface soit par diffusion d'impuretés à partir d'une couche dopée déposé à la surface.

L'intérêt de ce gradient de concentration est de pouvoir augmenter l'efficacité quantique dans la première région d'intérêt RI₁, dédiée à la plus faible longueur d'onde d'intérêt. En effet, grâce à ce gradient de concentration, les charges photo-générées sont éloignées des centres de recombinaison à proximité de la face active FA.

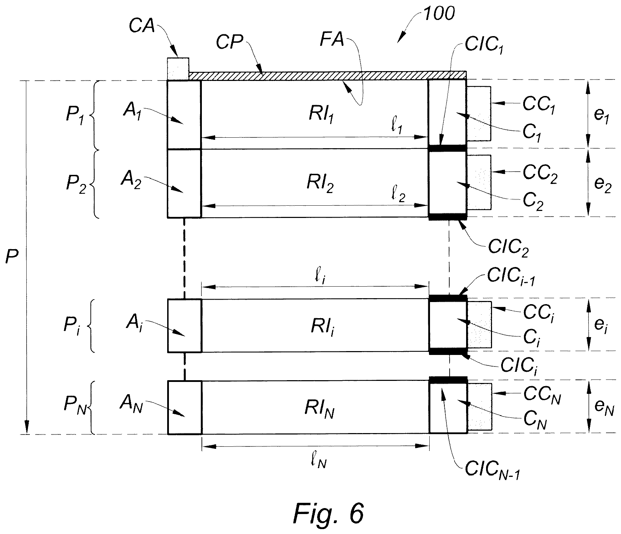

La figure 6 représente une autre variante applicable aux quatre modes de réalisation décrits précédemment.

Elle est toutefois fournie en référence au premier mode de réalisation.

Dans cette variante, le photodétecteur multi-spectral comporte une couche de passivation CP sur la face active FA.

La couche de passivation CP peut être réalisée avec un oxyde ou du verre comportant du phosphore.

Cette couche de passivation permet de protéger le photodétecteur multi-spectral contre les agressions éventuelles du milieu extérieur (par exemple, humidité, corrosion).

Elle permet également de réduire les états d'interface au niveau de la face active. En effet, les atomes dans la première couche atomique de la matière du premier photodétecteur P₁ présentent des liaisons incomplètes ou pendantes au niveau de la face active, par exemple pour une interface de type Si/SiO₂. En l'absence de couche de passivation, ces liaisons pendantes constituent des centres de recombinaisons qui réduisent l'efficacité quantique et génèrent du bruit.

Elle peut aussi permettre de retenir les défauts de charge ionique, en particulier lorsqu'un verre au phosphore est employé pour former cette couche de passivation CP.

Enfin, selon une autre variante, on pourra à la fois prévoir, quel que soit le mode de réalisation envisagé, à la fois un gradient de concentration tel que représenté sur la figure 5 et une couche de passivation telle que représentée sur la figure 6.

### Exemple

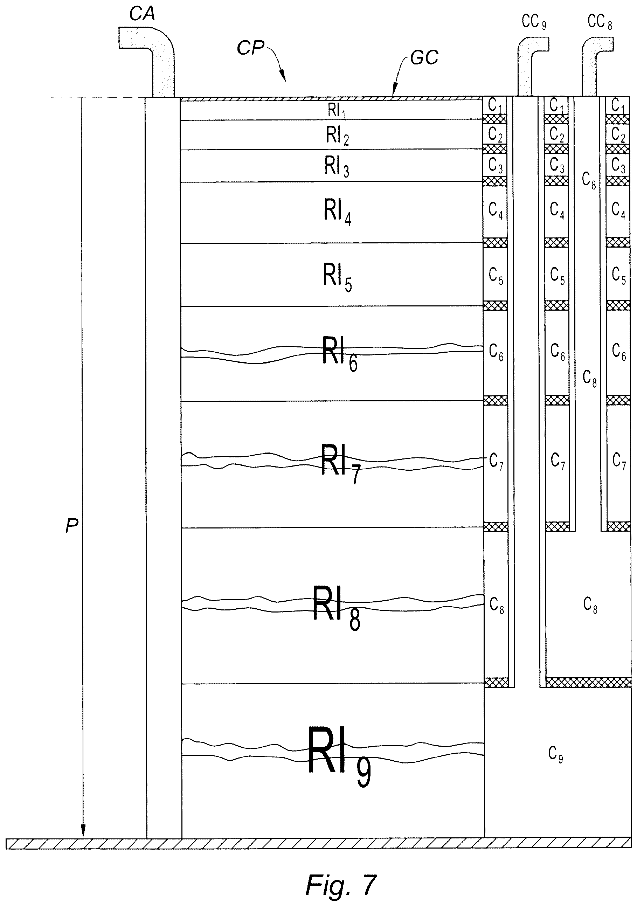

Cet exemple est basé sur la structure de la figure 5, avec N = 9 photodétecteurs empilés. Nous avons cependant représenté sur la figure 7, la structure du capteur multi-spectral de façon plus précise pour cet exemple. En particulier, la réalisation des différents contacts est représentée.

Le tableau 1 ci-dessous fournit, pour chaque photodétecteur Pi, sa largeur Iᵢ et son épaisseur eᵢ, avec 1 ≤ i ≤ 9. La profondeur dᵢ de chaque photodétecteur Pᵢ peut être déduite à partir des valeurs cumulées des épaisseurs de chaque photodétecteur qui le précède dans l'empilement.

**Tableau 1**

| Photodétecteur | Iᵢ (microns) | eᵢ(nm) |
|---|---|---|
| P1 | 1 | 50 |
| P2 | 1 | 100 |
| P3 | 1 | 100 |
| P4 | 1 | 200 |
| P5 | 1 | 200 |
| P6 | 1 | 300 |
| P7 | 1 | 2000 |
| P8 | 1 | 3000 |
| P9 | 1 | 3000 |

La face active FA présente une surface de 1µm². Compte tenu du fait que Iᵢ vaut 1 micron, cela signifie que la face active présente une forme carrée dans un plan perpendiculaire au plan de représentation de la figure 7.

Les photodétecteurs sont en silicium.

### Description du procédé de réalisation

On part d'un substrat en silicium, dope P⁻ à 10¹⁵ atomes par cm³.

On implante du Bore sur toute la surface avec une dose telle que le dopage soit de 5.1017 cm⁻³ sur une épaisseur de 30 nm.

### Réalisation du photodétecteur P₉ (le plus profond), d'épaisseur e₉ = 3 µm

Epitaxie d'une couche de silicium cristallin dopée à 10¹⁴ at.cm⁻³ en Bore sur une épaisseur de 1,5 µm.

Définir avec un masque, par un dépôt de résine photosensible et photolithographie, les zones d'anode et de cathode.

Implanter à travers ces masques respectivement P⁺ et N⁺ avec des dopages au moins égaux à 10¹⁹ at.cm⁻³.

Epitaxie d'une couche de silicium cristallin dopée à 10¹⁴ at.cm⁻³ en Bore sur une épaisseur de 1,485 µm.

Définir avec un masque, par un dépôt de résine photosensible et photolithographie, les zones d'anode et de cathode.

Implanter à travers ces masques respectivement P+ (anode) et N+ (cathode) avec des dopages au moins égaux à 10¹⁹ at.cm⁻³.

Epitaxie d'une couche de silicium cristallin dopée a 10¹⁴ at.cm⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes (couche CIC_{N-1}) et la colonne permettant de remonter la cathode C₉ jusqu'à la face active FA. Nous devons alors définir avec un masque, par un dépôt de résine photosensible et photolithographie, la région d'isolation implanté P⁺. Un implant P⁺ à 10²⁰ at.cm⁻³ est réalisé à travers ce masque. Cet implant présente une épaisseur de 30nm.

Un autre masque permet de définir la région N⁺ à 10¹⁹ at.cm⁻³ qui constitue la colonne correspondant à C₉.

### Réalisation du photodétecteur P₈, d'épaisseur e₈ = 3 µm

Epitaxie d'une couche de silicium cristallin dopée a 10¹⁴ at.cm⁻³ en Bore sur une épaisseur de 1,5 µm.

Définir avec un masque, par un dépôt de résine photosensible et photolithographie, les zones d'anode et de cathode ainsi que la couronne d'isolation dans la région de la cathode qui entoure la colonne remontant de C₉. Implanter à travers les masques d'anode et de cathode respectivement P⁺, N⁺ avec des dopages au moins égaux à 10¹⁹ at.cm⁻³.

Implanter à travers la couronne d'isolation du P⁺ dopé à 10²⁰ at.cm⁻³.

Epitaxie d'une couche de silicium cristallin dopée a 10¹⁴ at.cm⁻³ en Bore sur une épaisseur de 1,47 µm.

Définir avec un masque, par un dépôt de résine photosensible et photolithographie, les zones d'anode et de cathode ainsi que la couronne d'isolation dans la région de la cathode qui entoure la colonne remontant de C₉.

Implanter à travers les masques d'anode et de cathode respectivement P⁺, N⁺ avec des dopages au moins égaux à 10¹⁹ at.cm⁻³.

Implanter à travers la couronne d'isolation du P⁺ dopé à 10²⁰ at.cm⁻³.

Epitaxie d'une couche de silicium cristallin dopée à 10¹⁴ at.m⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes et les colonnes permettant de remonter les cathodes C₈ et C₉ jusqu'à la surface active FA. Nous devons alors définir avec un masque, par un dépôt de résine photosensible et photolithographie, la région d'isolation implanté P⁺. Un implant P⁺ à 10²⁰ at.cm⁻³ est réalisé à travers ce masque. Cet implant présente une épaisseur de 30nm.

Un autre masque permet de définir les régions N⁺ à 10¹⁹ at.cm⁻³ qui constituent les colonnes correspondant à C₈ et C₉.

### Réalisation du photodétecteur P₇, d'épaisseur e₇ = 2 µm

Epitaxie d'une couche de silicium cristallin dopée à 10¹⁴ at.cm⁻³ en Bore sur une épaisseur de 1 µm.

Définir avec un masque, par un dépôt de résine photosensible et photolithographie, les zones d'anode et de cathode et les couronnes d'isolation dans la région de la cathode qui entourent les colonnes remontant de C₈ et C₉.

Implanter à travers les masques d'anode et de cathode respectivement P⁺, N⁺ avec des dopages au moins égaux à 10¹⁹ at.cm⁻³.

Implanter à travers les couronnes d'isolation du P⁺ dopé à 10²⁰ at.cm⁻³.

Epitaxie d'une couche de silicium cristallin dopée à 10¹⁴ at.cm⁻³ en Bore sur une épaisseur de 0,97 µm.

Définir avec un masque, par un dépôt de résine photosensible et photolithographie, les zones d'anode et de cathode et les couronnes d'isolation dans la région de la cathode qui entourent les colonnes remontant de C₈ et C₉.

Implanter à travers les masques d'anode et de cathode respectivement P⁺, N⁺ avec des dopages au moins égaux à 10¹⁹ at.cm⁻³.

Implanter à travers les couronnes d'isolation du P⁺ dopé à 10²⁰ at.cm⁻³.

Epitaxie d'une couche de silicium cristallin dopée à 10¹⁴ at.m⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes et les colonnes permettant de remonter les cathodes C₇, C₈ et C₉ jusqu'à la surface active FA. Nous devons alors définir avec un masque, par un dépôt de résine photosensible et photolithographie, la région d'isolation implanté P⁺. Un implant P⁺ à 10²⁰ at.cm⁻³ est réalisé à travers ce masque. Cet implant présente une épaisseur de 30nm.

Un autre masque permet de définir les régions N⁺ à 10¹⁹ at.cm⁻³ qui constituent les colonnes correspondant à C₇, C₈ et C₉.

### Réalisation du photodétecteur P₆, d'épaisseur e₆ = 300 nm

Epitaxie d'une couche dopée à 10¹⁴ at.m⁻³ en Bore sur une épaisseur de 270 nm.

Définir avec un masque, par un dépôt de résine photosensible et photolithographie, les zones d'anode et de cathode et les couronnes d'isolation dans la région de la cathode qui entourent les colonnes remontant de C₇, C₈ et C₉.

Implanter à travers les masques d'anode et de cathode respectivement P⁺, N⁺ avec des dopages au moins égaux à 10¹⁹ at.cm⁻³.

Implanter à travers les couronnes d'isolation du P⁺ dopé à 10²⁰ at.cm-³.

Epitaxie d'une couche de silicium cristallin dopée à 10¹⁴ at.m⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes et les colonnes permettant de remonter les cathodes C₆, C₇, C₈ et C₉ jusqu'à la face active FA. Nous devons alors définir avec un masque, par un dépôt de résine photosensible et photolithographie, la région d'isolation implanté P⁺. Un implant P⁺ à 1 10²⁰ at.cm⁻³ est réalisé à travers ce masque. Cet implant présente une épaisseur de 30nm.

Un autre masque permet de définir les régions N⁺ 1 10¹⁹ at.cm⁻³ qui constituent les colonnes correspondant à C₆, C₇, C₈ et C₉.

### Réalisation du photodétecteur P₅, d'épaisseur e₅ = 200 nm

Epitaxie d'une couche dopée à 10¹⁴ at.m⁻³ en Bore sur une épaisseur de 170 nm.

Définir avec un masque, par un dépôt de résine photosensible et photolithographie, les zones d'anode et de cathode et les couronnes d'isolation dans la région de la cathode qui entourent les colonnes remontant de C₆, C₇, C₈ et C₉.

Implanter à travers les masques d'anode et de cathode respectivement P⁺, N⁺ avec des dopages au moins égaux à 10¹⁹ at.cm⁻³.

Implanter à travers les couronnes d'isolation du P⁺ dopé à 10²⁰ at.cm⁻³.

Epitaxie d'une couche de silicium cristallin dopée à 10¹⁴ at.m⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes et les colonnes permettant de remonter les cathodes C₅, C₆, C₇, C₈ et C₉ jusqu'à la face active FA. Nous devons alors définir avec un masque, par un dépôt de résine photosensible et photolithographie, la région d'isolation implanté P⁺. Un implant P⁺ à 10²⁰ at.cm⁻³ est réalisé à travers ce masque. Cet implant présente une épaisseur de 30nm.

Un autre masque permet de définir les régions N⁺ à 10¹⁹ at.cm⁻³ qui constituent les colonnes correspondant à C₅, C₆, C₇, C₈ et C₉.

### Réalisation du photodétecteur P₄. d'épaisseur e₄ = 200 nm

Epitaxie d'une couche dopée à 10¹⁴ at.m⁻³ en Bore sur une épaisseur de 170 nm.

Définir avec un masque, par un dépôt de résine photosensible et photolithographie, les zones d'anode et de cathode et les couronnes d'isolation dans la région de la cathode qui entourent les colonnes remontant de C₅, C₆, C₇, C₈ et C₉.

Implanter à travers les masques d'anode et de cathode respectivement P⁺, N⁺ avec des dopages au moins égaux à 10¹⁹ at.cm⁻³.

Implanter à travers les couronnes d'isolation du P⁺ dopé à 10²⁰ at.cm⁻³.

Epitaxie d'une couche de silicium cristallin dopée à 10¹⁴ at.m⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes et les colonnes permettant de remonter les cathodes C₄, C₅, C₆, C₇, C₈ et C₉ jusqu'à la face active FA. Nous devons alors définir avec un masque, par un dépôt de résine photosensible et photolithographie, la région d'isolation implanté P⁺. Un implant P⁺ à 10²⁰ at.cm⁻³ est réalisé à travers ce masque. Cet implant présente une épaisseur de 30nm.

Un autre masque permet de définir les régions N⁺ à 10¹⁹ at.cm⁻³ qui constituent les colonnes correspondant à C₄, C₅, C₆, C₇, C₈ et C₉.

### Réalisation du photodétecteur P₃, d'épaisseur e₃ = 100 nm

Epitaxie d'une couche dopée à 10¹⁴ at.m⁻³ en Bore sur une épaisseur de 70 nm.

Définir avec un masque, par un dépôt de résine photosensible et photolithographie, les zones d'anode et de cathode et couronnes d'isolation dans la région de la cathode qui entourent les colonnes remontant de C₄, C₅, C₆, C₇, C₈ et C₉.

Implanter à travers les masques d'anode et de cathode respectivement P⁺, N⁺ avec des dopages au moins égaux à 10¹⁹ at.cm⁻³.

Implanter à travers les couronnes d'isolation du P⁺ dopé à 10²⁰ at.cm⁻³.

Epitaxie d'une couche de silicium cristallin dopée à 10¹⁴ at.m⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes et les colonnes permettant de remonter les cathodes C₃, C₄, C₅, C₆, C₇, C₈ et C₉ jusqu'à la face active FA. Nous devons alors définir avec un masque, par un dépôt de résine photosensible et photolithographie, la région d'isolation implanté P⁺. Un implant p⁺ à 10²⁰ at.cm⁻³ est réalisé à travers ce masque. Cet implant présente une épaisseur de 30nm.

Un autre masque permet de définir les régions N⁺ à 10¹⁹ at.cm⁻³ qui constituent les colonnes correspondant à C₃, C₄, C₅, C₆, C₇, C₈ et C₉.

### Réalisation du photodétecteur P₂, d'épaisseur e₂ = 100 nm

Epitaxie d'une couche dopée à 10¹⁴ at.m⁻³ en Bore sur une épaisseur de 70 nm.

Définir avec un masque, par un dépôt de résine photosensible et photolithographie, les zones d'anode et de cathode et les couronnes d'isolation dans la région de la cathode qui entourent les colonnes remontant de C₃, C₄, C₅, C₆, C₇, C₈ et C₉,

Implanter à travers les masques d'anode et de cathode respectivement P⁺, N⁺ avec des dopages au moins égaux à 10¹⁹ at.cm⁻³.

Implanter à travers les rings d'isolation du P⁺ dopé à 10²⁰ at.cm⁻³.
Epitaxie d'une couche de silicium cristallin dopée à 10¹⁴ at.m⁻³ en Bore sur une épaisseur de 30 nm.

Définir la zone d'anode en utilisant le même masque que précédemment et l'implanter P⁺ à 10¹⁹ at.cm⁻³.

Définir la zone d'implant d'isolation des cathodes et les colonnes permettant de remonter les cathodes C₂, C₃, C₄, C₅, C₆, C₇, C₈ et C₉ jusqu'à la face active FA. Nous devons alors définir avec un masque, par un dépôt de résine photosensible et photolithographie, la région d'isolation implanté P⁺. Un implant P⁺ à 10²⁰ at.cm⁻³ est réalisé à travers ce masque. Cet implant présente une épaisseur de 30nm.

Un autre masque permet de définir les régions N⁺ à 10¹⁹ at.cm⁻³ qui constituent les colonnes correspondant à C₂, C₃, C₄, C₅, C₆, C₇, C₈ et C₉.

### Réalisation du photodétecteur P₁, d'épaisseur e₁ = 50 nm

Epitaxie d'une couche dopée à 10¹⁴ at.m⁻³ en Bore sur une épaisseur de 35 nm.

Définir avec un masque, par un dépôt de résine photosensible et photolithographie, les zones d'anode et de cathode et les couronnes d'isolation dans la région de la cathode qui entourent les colonnes remontant de C₂, C₃, C₄, C₅, C₆, C₇, C₈ et C₉.

Implanter à travers les masques d'anode et de cathode respectivement P⁺, N⁺ avec des dopages au moins égaux à 10¹⁹at.cm⁻³.

Implanter à travers les couronnes d'isolation du P⁺ dopé à 10²⁰ at.cm⁻³.

### Implantation d'un gradient de concentration (GA) au niveau de la face active FA

Implantation sur toute la face active FA d'une dopage P à 10¹⁷ at.cm⁻³.

### Réalisation de la couche de passivation (CP)

Un premier traitement thermique est réalisé pour l'activation des dopants dans les différentes épitaxies. Ce traitement peut être de type « fast rtp » a 1000 °C. Par exemple, nous pouvons réaliser une montée en température (« Ramp-up ») de 600 °C à 1000 °C à 300°C/min sous atmosphère neutre. On réalise ensuite un palier de 30 secondes en atmosphère légèrement oxydante (90% azote et 10% d'oxygène) a 1000 °C. On effectue ensuite une descente en température (« Ramp down ») à 300°C/min jusqu'à 600 °C sous atmosphère neutre. Finalement, on effectue un dépôt de verre au phosphore (PSG : SiO₂ avec 8% de phosphore) de 500 nm d'épaisseur, suivi d'un recuit à 600°C pendant 30 minutes sous atmosphère de 90% N₂ et 10% H₂.

### Métallisation et définition des contacts

Cette étape permet de prendre contact sur chacune des cathodes afin de les connecter à l'électronique de lecture destinée à être réalisée sur la même puce. Elle permet aussi de connecter l'anode et de fixer les polarisations nécessaires au fonctionnement du capteur 100 multi-spectral.

Fin du procédé de réalisation.

Il convient de noter que, comme indiqué précédemment, le procédé de fabrication décrit ci-dessus est compatible avec les technologies « planar » de fabrication de Cl, CMOS ou BiCMOS, du fait de la façon dont est réalisé le lien et l'isolation entre les contacts des différentes cathodes.

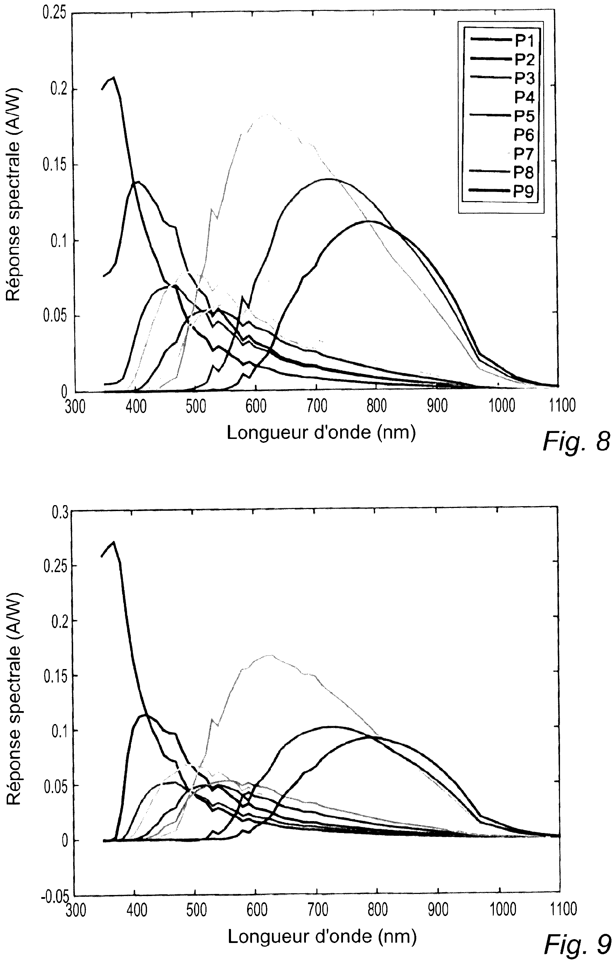

La figure 8 représente les courbes de réponse spectrale, obtenues par simulation numérique, du capteur multi-spectral de la figure 7.

En pratique cependant, pour que cela fonctionne, il conviendra probablement d'appliquer une polarisation comprise entre 5V et 10V entre l'anode et la cathode.

### Autre exemple

Un capteur multi-spectral conforme à celui de la figure 7, mais prévoyant en plus des languettes Lᵢ et des couches d'isolation CIⱼ entre les régions d'intérêt, comme proposé sur la figure 3, a également été simulée.

Le procédé de fabrication d'une telle structure serait similaire à celui décrit précédemment pour réaliser la structure de la figure 7, à l'exception du fait qu'il convient de prévoir une languette dans chaque photodétecteur ainsi que la couche d'isolation entre régions d'intérêt.

A cet effet, chaque languette Lᵢ présente une épaisseur de 20nm.

Pour cela, on prévoit de faire l'épitaxie du photodétecteur Pᵢ en plusieurs étapes. On réalise l'épitaxie du photodétecteur comme dans le cas du photodétecteur P9 de l'exemple précédent. Ensuite, on définit un masque, par un dépôt de résine photosensible et photolithographie pour l'anode, la cathode et la zone de languette. Puis, on réalise une implantation ionique à travers le masque correspondant à chaque région. Pour la languette, l'implantation peut être effectuée avec un dopage de même type que celui de la cathode, cependant inférieur à celui de la cathode. On continue ensuite l'épitaxie jusqu'à l'épaisseur visée pour le photodétecteur P_{N}. Enfin, on réalise les implants d'isolation (cathode et région d'intérêt).

Ceci est répété pour chaque photodétecteur de l'empilement.

Un tel capteur multi-spectral n'a besoin que d'une faible polarisation inverse entre l'anode et la cathode. Dans le cas d'espèce, la structure particulière décrite précédemment peut fonctionner avec une polarisation inverse nulle (0 Volt).

La figure 9 représente les courbes de réponses spectrales, obtenues par simulation numérique, d'un tel capteur multi-spectral.

Il convient de noter que dans l'ensemble des modes de réalisation décrits précédemment, variantes comprises, le capteur multi-spectral est conçu pour récupérer les charges photo-générées au niveau de la cathode du photodétecteur concerné.

Ceci explique pourquoi il est prévu un contact CCᵢ par cathode Cᵢ. Ceci explique également pourquoi on peut prévoir un contact commun CA pour l'ensemble des anodes.

Pour autant, on pourrait parfaitement prévoir un contact d'anode par anode (non représenté).

Par ailleurs, un capteur multi-spectral conforme à l'invention peut prévoir de récupérer les charges photo-générées dans chaque photodétecteur Pᵢ dans les anodes.

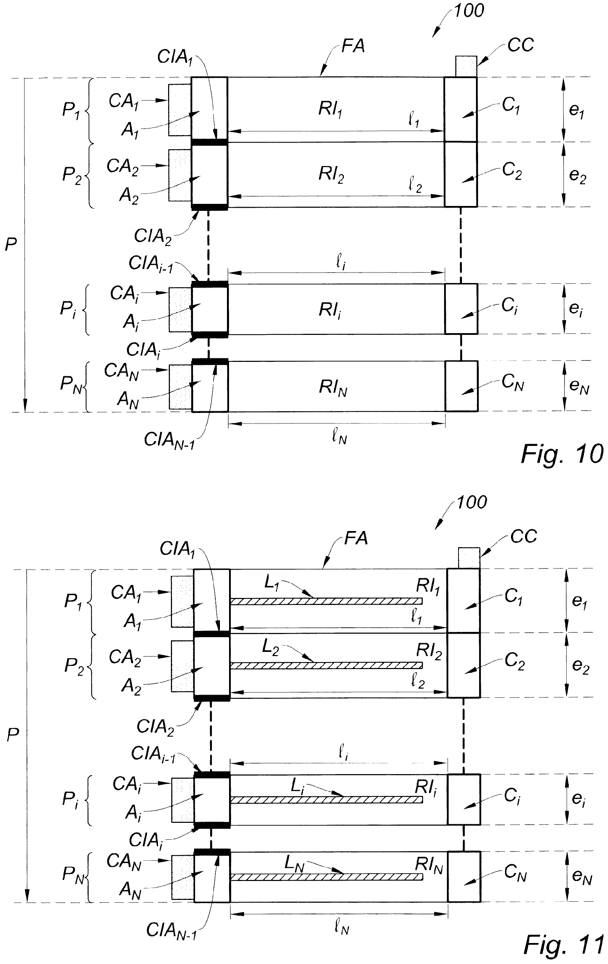

Dans ce cas, et comme représenté sur la figure 10, il convient de prévoir autant de contacts d'anodes CA₁, CA₂, ..., CAᵢ, CA_{N} qu'il y a d'anodes. Les couches d'isolation CIA₁, CIA₂,..., CIAᵢ₋₁, CIAᵢ, ..., CIA_{N-1} seront alors prévues entre les anodes qui se font face dans l'empilement.

Dans ce cas également, il est envisageable de prévoir un contact commun CC par cathode, même si l'on peut bien entendu prévoir un contact par cathode.

La figure 10 est à comparer à la figure 1.

Cette modification n'a pas d'impact sur le fonctionnement du capteur multi-spectral conforme à l'invention. En effet, il s'agit simplement ici d'une conception alternative pour récupérer les charges photo-générées par le photodétecteur concerné.

Pour cette raison, l'invention concerne également un capteur 100 multi-spectral comprenant :
- une pluralité de N photodétecteurs P₁,..., P_{N} avec N un nombre entier tel que N ≥2, chaque photodétecteur comportant une anode A₁, ..., AN et une cathode C₁, ..., C_{N} séparées l'une de l'autre par une région d'intérêt R_{I1}, ..., R_{IN}, l'anode, la cathode et la région d'intérêt étant toutes réalisées en un matériau semi-conducteur ;
   lesdits photodétecteurs étant empilés les uns sur les autres de sorte que les anodes A₁, ..., A_{N} d'une part, les cathodes C₁, ..., C_{N} d'autre part et les régions d'intérêt R_{I1}, ..., R_{IN} enfin de deux photodétecteurs consécutifs dans l'empilement soient agencées face à face, cet empilement permettant de définir une face dite face active FA du capteur multi-spectral, commune à l'ensemble des photodétecteurs de l'empilement, définie par la face de la première région d'intérêt RI₁ du premier photodétecteur P₁ de l'empilement par laquelle des photons sont destinés à entrer dans l'empilement ;
- un contact électrique CA₁, ..., CA_{N} associé à chacune des N anodes, les anodes consécutives dans l'empilement, agencées face à face, étant alors séparées par une couche d'isolation CIA₁, ..., CIA_{N} ; et
- au moins un contact électrique CC pour les N cathodes, les anodes consécutives dans l'empilement, agencées face à face.

Tous les autres modes de réalisation décrits à l'appui des figures 2 à 6 sont également applicables, *mutadis mutandis,* au cas de la figure 10.

En particulier, il est tout à fait envisageable de prévoir que chaque photodétecteur Pᵢ comporte, au sein de la région d'intérêt Rᵢ associée, une languette Lᵢ au moins en contact avec l'anode Ai concernée et réalisée avec un dopage du même type que cette anode Aᵢ, ladite languette Li s'étendant, au sein de la région d'intérêt Rᵢ, en direction de la cathode Cᵢ.

Dans ce cas, la languette Lᵢ a la même fonction que celle décrite précédemment.

Ceci est représenté sur la figure 11.

Pour fabriquer une telle languette, on pourra notamment prévoir une dopage plus faible que pour celui de l'anode correspondante.

Enfin, on peut envisager un capteur multi-spectral dans lequel on prévoit un contact électrique CCᵢ pour chaque cathode Cᵢ et un contact électrique CAᵢ pour chaque anode Aᵢ ainsi que des couches d'isolation ClAᵢ entre les anodes qui se font face dans l'empilement d'une part et des couches d'isolation CCᵢ entre les cathodes qui se font face d'autre part.

## Revendications

1. Capteur (100, 100', 100") mufti-spectral comprenant :
- une pluralité de N photodétecteurs (P₁,..., P_{N}) avec N un nombre entier tel que N ≥2, chaque photodétecteur comportant une anode (A₁, ..., A_{N}) et une cathode (C₁, ..., C_{N}) séparées l'une de l'autre par une région d'intérêt (R_{I1}, ..., R_{IN}), l'anode, la cathode et la région d'intérêt étant toutes réalisées en un matériau semi-conducteur ; **caractérisé en ce que** lesdits photodétecteurs étant empilés les uns sur les autres de sorte que les anodes (A₁, ..., A_{N}) d'une part, les cathodes (C₁, ..., C_{N}) d'autre part et les régions d'intérêt (R_{I1}, ..., R_{IN}) enfin de deux photodétecteurs consécutifs dans l'empilement soient agencées face à face, cet empilement permettant de définir une face dite face active (FA) du capteur multi-spectral, commune à l'ensemble des photodétecteurs de l'empilement, définie par la face de la première région d'intérêt (RI₁) du premier photodétecteur (P₁) de l'empilement par laquelle des photons sont destinés à entrer dans l'empilement ; et
- soit, dans un premier cas, un contact électrique (CC₁, ..., CC_{N}) associé à chacune des N cathodes et au moins un contact électrique (CA) pour les N anodes (A1, ..., A_{N}), les cathodes consécutives dans l'empilement, agencées face à face, étant alors séparées par une couche d'isolation (CIC₁, ..., CIC_{N}) ;
- soit, dans un deuxième cas, un contact électrique (CA₁, ..., CA_{N}) associé à chacune des N anodes et au moins un contact électrique (CC) pour les N cathodes, les anodes consécutives dans l'empilement, agencées face à face, étant alors séparées par une couche d'isolation (CIA₁, ..., CIA_{N}).

2. Capteur (100, 100', 100") multi-spectral selon la revendication 1, comprenant, entre deux photodétecteurs consécutifs (Pᵢ, Pᵢ₊₁ avec 1 ≤ i ≤ N-1) dans l'empilement, une couche d'isolation (CIᵢ) séparant les régions d'intérêt (RIᵢ) agencées face à face.

3. Capteur (100, 100', 100") multi-spectral selon l'une des revendications précédentes, dans lequel chaque photodétecteur (Pᵢ) comporte, au sein de la région d'intérêt (RIᵢ) associée, une languette (L) qui est :
- dans le premier cas, au moins en contact avec la cathode concernée et réalisée avec un dopage du même type que cette cathode, ladite languette s'étendant, au sein de la région d'intérêt, en direction de l'anode ;
- dans le deuxième cas, au moins en contact avec l'anode concernée et réalisée avec un dopage du même type que cette anode, ladite languette s'étendant, au sein de la région d'intérêt, en direction de la cathode.

4. Capteur (100, 100', 100") multi-spectral selon la revendication précédente, dans lequel la ou chaque languette présente une épaisseur comprise entre 10nm et 50nm.

5. Capteur (100, 100', 100") multi-spectral selon l'une des revendications précédentes, comprenant, un gradient de concentration (GC) du dopage du matériau semi-conducteur de la région d'intérêt (RI₁) du premier photodétecteur (P₁) de l'empilement, situé au niveau de ladite face active.

6. Capteur (100, 100', 100") multi-spectral selon l'une des revendications précédentes, comprenant, en outre, une couche de passivation (CP) sur ladite face active (FA).

7. Capteur (100, 100', 100") multi-spectral selon la revendication précédente, dans lequel la couche de passivation (CP) est réalisée avec un oxyde ou du verre comportant du phosphore.

8. Capteur (100, 100', 100") multi-spectral selon l'une des revendications précédentes, dans lequel il est prévu une couche isolante (CIS₁, ..., CIS_{N}), par exemple réalisée avec un oxyde :
- dans le premier cas, entre chaque contact électrique (CC₁, ..., CC_{N}) de la cathode et la cathode (C₁, ..., C_{N}) associée afin de former un condensateur entre le contact électrique de la cathode et la cathode associée,
- dans le deuxième cas, entre chaque contact électrique (CA₁, ..., CA_{N}) de l'anode et l'anode (C₁, ..., C_{N}) associée afin de former un condensateur entre le contact électrique de l'anode et l'anode associée.

9. Capteur (100, 100', 100") selon l'une des revendications précédentes, dans lequel, pour chaque photodétecteur (P₁, ..., P_{N}), la région d'intérêt (RI₁, ..., RI_{N}) est réalisée en un matériau semi-conducteur intrinsèquement dopé.

10. Capteur (100, 100', 100") multi-spectral selon l'une des revendications précédentes, dans lequel, pour chaque photodétecteur (P₁, ..., P_{N}) :
- l'anode (A₁, ..., A_{N}) est réalisée en un matériau semi-conducteur dopé P+ ;
- la cathode (C₁, ..., C_{N}) est réalisée en un matériau semi-conducteur dopé N+.

## Patentansprüche

1. Multispektraler Sensor (100, 100', 100"), umfassend:
- eine Vielzahl von N Photodetektoren (P₁,... P_{N}), wobei N eine ganze Zahl derart ist, dass N ≥ 2, wobei jeder Photodetektor eine Anode (A₁, ..., A_{N}) und eine Kathode (C₁, ..., C_{N}) umfasst, die durch eine Region von Interesse (R_{I1}, ..., RI_{N}) voneinander getrennt sind, wobei die Anode, die Kathode und die Region von Interesse alle aus einem Halbleitermaterial bestehen; **dadurch gekennzeichnet, dass** die Photodetektoren so übereinander gestapelt sind, dass die Anoden (A₁, ..., A_{N}) einerseits, die Kathoden (C₁, ..., C_{N}) andererseits, und die Regionen von Interesse (R_{I1}, ..., R_{IN}) schließlich von zwei aufeinanderfolgenden Photodetektoren in dem Stapel einander gegenüberliegend angeordnet sind, wobei dieser Stapel es ermöglicht, eine Fläche, genannt aktive Fläche (FA), des multispektralen Sensors zu definieren, die der Gesamtheit der Photodetektoren des Stapels gemeinsam ist, definiert durch die Fläche der ersten Region von Interesse (RI₁) des ersten Photodetektors (P₁) des Stapels, durch die die Photonen in den Stapel eintreten sollen; und
- entweder, in einem ersten Fall, einen elektrischen Kontakt (CC₁, ..., CC_{N}), der jeder der N Kathoden zugeordnet ist, und mindestens einen elektrischen Kontakt (CA) für die N Anoden (A₁, ..., A_{N}), wobei die aufeinanderfolgenden Kathoden in dem Stapel, die einander gegenüberliegend angeordnet sind, dann durch eine Isolierschicht (CIC₁, ..., CIC_{N}) getrennt werden;
- oder, in einem zweiten Fall, einen elektrischen Kontakt (CA₁, ..., CA_{N}), der jeder der N Anoden zugeordnet ist, und mindestens einen elektrischen Kontakt (CC) für die N Kathoden, wobei die aufeinanderfolgenden Anoden, die in dem Stapel einander gegenüberliegend angeordnet sind, dann durch eine Isolierschicht (CIA₁, ..., CIA_{N}) getrennt werden.

2. Multispektraler Sensor (100, 100', 100") nach Anspruch 1, umfassend, zwischen zwei aufeinanderfolgenden Photodetektoren (Pᵢ, Pᵢ+₁ mit 1 ≤ i ≤ N-1) in dem Stapel, eine Isolierschicht (CIᵢ), welche die Regionen von Interesse (RIᵢ) trennt, die einander gegenüberliegend angeordnet sind.

3. Multispektraler Sensor (100, 100', 100") nach einem der vorstehenden Ansprüche, wobei jeder Photodetektor (Pᵢ) innerhalb der zugeordneten Region von Interesse (RIᵢ) eine Lasche (Lᵢ) umfasst, die:
- im ersten Fall zumindest in Kontakt mit der betreffenden Kathode steht und mit einer Dotierung desselben Typs wie diese Kathode hergestellt ist, wobei sich die Lasche innerhalb der Region von Interesse in Richtung der Anode erstreckt;
- im zweiten Fall zumindest in Kontakt mit der betreffenden Anode steht und mit einer Dotierung desselben Typs wie diese Anode hergestellt ist, wobei sich die Lasche innerhalb der Region von Interesse in Richtung der Kathode erstreckt.

4. Multispektraler Sensor (100, 100', 100") nach dem vorstehenden Anspruch, wobei die oder jede Lasche eine Dicke zwischen 10 nm und 50 nm aufweist.

5. Multispektraler Sensor (100, 100', 100") nach einem der vorstehenden Ansprüche, umfassend einen Konzentrationsgradienten (GC) der Dotierung des Halbleitermaterials der Region von Interesse (RI₁) des ersten Photodetektors (P₁) des Stapels, der sich auf Höhe der aktiven Fläche befindet.

6. Multispektraler Sensor (100, 100', 100') nach einem der vorstehenden Ansprüche, weiter umfassend eine Passivierungsschicht (CP) auf der aktiven Fläche (FA).

7. Multispektraler Sensor (100, 100', 100") nach dem vorstehenden Anspruch, wobei die Passivierungsschicht (CP) aus einem Oxid oder Glas, Phosphor umfassend, hergestellt ist.

8. Multispektraler Sensor (100, 100', 100") nach einem der vorstehenden Ansprüche, wobei eine isolierende Schicht (CIS₁, ..., CIS_{N}) vorgesehen ist, die beispielsweise aus einem Oxyd hergestellt ist:
- im ersten Fall zwischen jedem elektrischen Kontakt (CC₁, ..., CC_{N}) der Kathode und der zugeordneten Kathode (C₁, ..., C_{N}), um einen Kondensator zwischen dem elektrischen Kontakt der Kathode und der zugeordneten Kathode zu bilden,
- im zweiten Fall zwischen jedem elektrischen Kontakt (CA₁, ..., CA_{N}) der Anode und der zugeordneten Anode (C₁, ..., C_{N}), um einen Kondensator zwischen dem elektrischen Kontakt der Anode und der zugeordneten Anode zu bilden.

9. Sensor (100, 100', 100") nach einem der vorstehenden Ansprüche, wobei für jeden Photodetektor (P₁, ..., P_{N}) die Region von Interesse (RI₁, ..., RI_{N}) aus einem intrinsisch dotierten Halbleitermaterial hergestellt ist.

10. Multispektraler Sensor (100, 100', 100") nach einem der vorstehenden Ansprüche, wobei für jeden Photodetektor (P₁, ..., P_{N}):
- die Anode (A₁, ..., A_{N}) aus einem P+-dotierten Halbleitermaterial hergestellt ist;
- die Kathode (C₁, ..., C_{N}) aus einem N+-dotierten Halbleitermaterial hergestellt ist.

## Claims

1. Multi-spectral sensor (100, 100', 100") comprising:
- a plurality of N photodetectors (P₁, ..., P_{N}) with N an integer such that N ≥ 2, each photodetector comprising an anode (A₁, ..., A_{N}) and a cathode (C₁, ..., C_{N}) separated from one another by a region of interest (R_{I1}, ..., R_{IN}), the anode, the cathode and the region of interest being all made of a semiconductor material; **characterised in that**
said photodetectors being stacked on top of each other so that the anodes (A₁, ..., A_{N}) on the one hand, the cathodes (C₁, ..., C_{N}) on the other hand, and the regions of interest (R_{I1}, ..., RI_{N}) finally of two consecutive photodetectors in the stack are arranged face to face, this stack making it possible to define a face, called active face (FA) of the multi-spectral photodetector, common to all the photodetectors of the stack, defined by the face of the first region of interest (RI₁) of the first photodetector (P₁) of the stack via which photons are intended to enter the stack; and
- either, in a first case, an electric contact (CC₁, ..., CC_{N}) associated with each of the N cathodes and at least one electric contact (CA) for the N anodes (A₁, ..., A_{N}), the consecutive cathodes in the stack, arranged face to face, thus being separated by an isolation layer (CIC₁, ..., CIC_{N});
- or, in a second case, an electric contact (CA₁, ..., CA_{N}) associated with each of the N anodes and at least one electric contact (CC) for the N cathodes, the consecutive anodes in the stack, arranged face to face, thus being separated by an isolation layer (CIA₁, ..., CIA_{N}).

2. Multi-spectral sensor (100, 100', 100") according to claim 1, comprising, between two consecutive photodetectors (Pᵢ, Pᵢ₊₁, with 1 ≤ i ≤ N-1) in the stack, an isolation layer (CIᵢ) separating the regions of interest (RIᵢ) arranged face to face.

3. Multi-spectral sensor (100, 100', 100") according to one of the preceding claims, wherein each photodetector (Pᵢ) comprises, within the associated region of interest (RIᵢ), a strip (Lᵢ) which is:
- in the first case, at least in contact with the cathode concerned and carried out with a doping of the same type as this cathode, said strip extending, within the region of interest, in the direction of the anode;
- in the second case, at least in contact with the anode concerned and carried out with a doping of the same type as this anode, said strip extending, within the region of interest, in the direction of the cathode.

4. Multi-spectral sensor (100, 100', 100") according to the preceding claim, wherein the or each strip presents a thickness comprised between 10nm and 50nm.

5. Multi-spectral sensor (100, 100', 100") according to one of the preceding claims, comprising, a concentration gradient (GC) of the doping of the semiconductive material of the region of interest (RI₁) of the first photodetector (P₁) of the stack, situated at the level of said active face.

6. Multi-spectral sensor (100, 100', 100") according to one of the preceding claims, further comprising a passivation layer (CP) on said active face (FA).

7. Multi-spectral sensor (100, 100', 100") according to the preceding claim, wherein the passivation layer (CP) is made with an oxide or glass comprising phosphorus.

8. Multi-spectral sensor (100, 100', 100") according to one of the preceding claims, wherein an isolating layer (CIS₁, ..., CIS_{N}) is provided, for example made with an oxide:
- in the first case, between each electric contact (CC₁, ..., CC_{N}) of the cathode and the associated cathode (C₁, ..., C_{N}) in order to form a capacitor between the electric contact of the cathode and the associated cathode,
- in the second case, between each electric contact (CA₁, ..., CA_{N}) of the anode and the associated anode (C₁, ..., C_{N}) in order to form a capacitor between the electric contact of the anode and the associated anode.

9. Sensor (100, 100', 100") according to one of the preceding claims, wherein, for each photodetector (P₁, ..., P_{N}), the region of interest (RI₁, ..., RI_{N}) is made of an intrinsically doped semiconductive material.

10. Multi-spectral sensor (100, 100', 100") according to one of the preceding claims, wherein, for each photodetector (P₁, ..., P_{N}):
- the anode (A₁, ..., A_{N}) is made of a P+ doped semiconductive material;
- the cathode (C₁, ..., C_{N}) is made of an N+ doped semiconductive material.
